# EUROPEAN PATENT APPLICATION

(11) **EP 2 136 400 A1**
(43) Date of publication of application: **23.12.2009**
(21) Application number: 08721792.3
(22) Date of filing: 11.03.2008
(51) Int. Cl.: H01L 23/373, H01L 23/12, H05K 1/02

(54) **RADIATING MEMBER, CIRCUIT BOARD USING THE MEMBER, ELECTRONIC PART MODULE, AND METHOD FOR MANUFACTURING THE MODULE**

(30) Priority: 12.03.2007 JP 2007062033
(71) Applicant: Toyo Tanso Co., Ltd., Osaka-shi Osaka 555-0011 (JP); Institute of National Colleges of Technology, Japan, Hachioji-shi, Tokyo 193-0834 (JP)
(72) Inventor: HIROSE, Yoshiaki, Mitoyo-shi Kagawa 769-1102 (JP); YUKI, Tetsuya, Mitoyo-shi Kagawa 769-1102 (JP); MISAKI, Yukinori, Mitoyo-shi Kagawa 769-1192 (JP); ARAKAWA, Masaki, Nakatado-gun Kagawa 764-0037 (JP)
(74) Representative: Glawe, Delfs, Moll
(86) International application number: PCT/JP2008/054376
(87) International publication number: WO 2008/126564

(57) **Abstract**

It is intended to provide a circuit board using a heat radiating member that can cool an electronic component sufficiently without causing a substrate to break, increasing the total weight of the substrate, lowering the productivity, or increasing cost and device size.
A circuit board has a substrate main body (4) having a wiring pattern (3) formed on a surface side, and a structure in which an LED module (1) is connected to the wiring pattern (3). The circuit board is **characterized in that**: a through hole (6) is provided in a portion of the substrate main body (4) so as to penetrate the substrate main body (4) from the surface side to a back side thereof; a heat radiating member (5) is provided on the back side of the substrate main body (4) so as to close one end of the through hole (6); and the LED module (1) is disposed in the through hole (6) so that the heat radiating member (5) and the LED module (1) are directly in contact with each other.

## Description

### TECHNICAL FIELD

The present invention relates to a heat radiating member, a circuit board having a heat radiating structure using the heat radiating member, an electronic component module, and methods of manufacturing them. More specifically, the invention relates to a heat radiating member made of a material that can be manufactured to have a varying heat capacity or the like, a circuit board and an electronic component module that have a heat radiating structure that is space saving, lightweight, low in cost and moreover capable of adjusting heat radiation capability. The invention further relates to manufacturing methods of them.

### BACKGROUND ART

A known conventional heat radiating structure for a circuit board has the following configuration. Metallic wiring lines are provided on one side of a substrate and electronic components are mounted on the wiring lines. A heat radiating plate made of copper, aluminum, or the like is in surface contact with the back side of the substrate. However, a heat radiating structure with higher heat radiation capability has been demanded because, for example, the amount of heat generated from the electronic components tends to increase more and more because of the recent increases in the processing speed and in packaging density, and LED, which have attracted attention as a lighting device, tends to cause degradation in luminous efficiency and failures when the temperature rises.

In particular, when LEDs are packaged at a high density, the amount of the heat generated increases according to the total amount of light, which leads to degradation in the characteristics of the LEDs and increase in the failure rate. Therefore, it is necessary to provide a heat radiating structure for suppressing temperature increase in order to cause a LED lighting device to emit light at a large light quantity.

A cooling means that utilizes the heat absorption effect of a Peltier device is also known as the heat radiating structure. However, problems with this cooling means involve difficulty in space saving and high costs. A method of dissipating heat providing a copper foil additionally on a circuit board to improve the heat conduction and letting the heat escape through an insulating sheet is also known. However, a problem is that, because the density of copper is relatively heavy, 9 g/cm³, the weight of the circuit board increases when a copper foil necessary for obtaining sufficient heat radiation capability is provided on the substrate.
In view of these problems, the following proposals have been made.

(1) A cooling structure is proposed in which graphite sheet or a monocrystalline sheet that is light in weight and has a higher thermal conductivity in a plane direction than various metals such as copper and aluminum is provided along a surface of, or on the back surface of, a substrate on which heat-radiating bodies, electronic devices, are mounted (see Patent Document 1 below).

(2) A printed circuit board with enhanced cooling capability is proposed. The printed circuit board has a through hole provided between an upper side and a lower side of a substrate main body. At least one electric component is attached on the upper side. The printed circuit board has at least one heat conductive member, inserted in the through hole, extending from the upper side to the lower side, and thermally coupled with the electric component. The heat conductive member has a planar top portion and a tapered or recessed bottom portion. (See Patent Document 2 below).

(3) A liquid crystal display device is provided. The liquid crystal display device has an LED backlight that can prevent the luminous efficiency of LED from degrading and can achieve highly reliable, bright, and long-life liquid crystal display. For this purpose, a mount metallic film, a metallic drive wiring line, and a metallic film pattern are formed on a mounting surface of a substrate on which an LED module is to be mounted, and a heat-radiating metal film is formed on a back surface. A portion therebetween is joined to a metallic through hole, and a heat radiating material is interposed between the module and the mount metallic film when mounting an LED module. (See Patent Document 3 below.)

[Patent Document 1] Japanese Published Unexamined Patent Application No. 2006-245388
[Patent Document 2] Japanese Published Unexamined Patent Application No. 2004-343112
[Patent Document 3] Japanese Published Unexamined Patent Application No. 2006-11239

### DISCLOSURE OF THE INVENTION

### PROBLEMS TO BE SOLVED BY THE INVENTION

### (1) Problems with the technique disclosed in Patent Document 1

This document discloses that a sheet made by treating a polymer substance such as polyimide at a high temperature treatment is attached on the bottom face of the substrate. However, in this structure, heat needs to be released through the printed circuit board, so it is difficult to show high heat radiation capability.

In addition, the sheet made by treating a polymer substance such as polyimide at a high temperature treatment has a low degree of freedom in shaping (i.e., the thickness of the sheet inevitably becomes thin) because of the constraint on the manufacturing method, in which the material such as polyimide is carbonized. Consequently, it is difficult to ensure a thickness that is necessary for obtaining high heat radiation capability. Moreover, the cost is high.

### (2) Problems with the technique disclosed in Patent Document 2

This document discloses a technique of forming a through hole in a printed circuit board and press-fitting a heat conductive member therein. However, contact between the electric component and the heat conductive member, and contact between the heat conductive member and a heat sink cannot be ensured sufficiently because the configuration is such that heat is conducted to a heat radiating member via the heat conductive member and the heat conductive member is made of a metal such as copper. Therefore, a problem arises that the electric component (electronic component) cannot be cooled sufficiently. This problem becomes noticeable when an LED module is packaged at a high density.

In addition, if the temperature of the heat conductive member becomes high and the heat conductive member undergoes thermal expansion, the substrate is put under a load, and the substrate may break. Moreover, the total weight of the substrate increases because the heat conductive member is made of a metal such as copper.
Furthermore, the configuration according to this document necessitates an additional manufacturing step that requires special equipment for press-fitting the heat conductive member, which leads to a decrease of the productivity and an increase in the cost. Another problem is that the size of the module increases corresponding to the height of the electric component since the structure is such that the electric component is disposed on the substrate surface.

### (3) Problems with the technique disclosed in Patent Document 3

This document describes that a heat radiating material is disposed between an LED module and a metallic through hole. However, the configuration, in which a through hole is formed in a mount substrate and metal is provided therein, is the same as that of the above-described Patent Document 2. Therefore, it has the same problems as Patent Document 2 except for the problems resulting from press-fitting the heat conductive member in the through hole.

### (4) Other Problems

The conventional heat radiating members are generally made of metal. Therefore, they cannot change the heat capacity unless the size or thickness thereof is changed. Accordingly, it is commonplace that the volume of the member is increased or decreased according to the increase or decrease of the required heat capacity. However, there is a problem that the increase or decrease in the volume of the heat radiating member requires redesigning of the arrangement of the components in the package, which may lead to an increase in the development cost or a delay in the development.

In view of the foregoing problems, it is an object of the present invention to provide a heat radiating member that can adjust the heat radiation characteristics of the heat radiating body by controlling the physical properties of a material.
It is another object of the invention to provide a heat radiating member that has high degree of freedom in shaping and high heat radiation capability and moreover that can be manufactured at low cost.

It is yet another object of the invention to provide a circuit board and an electronic component module using a heat radiating member that can cool an electronic component sufficiently without causing the substrate to break, increasing the total weight of the substrate, lowering the productivity, or increasing costs and device size, as well as manufacturing methods of them.

### MEANS FOR SOLVING THE PROBLEMS

The present inventors have focused attention on graphite material because the heat capacity thereof and the like can be varied in manufacture or the like. It is a material such that a change in the rise time that is a heat radiation characteristic and the temperature thereof in a steady state under heat radiation can be controlled in manufacture. The present inventors have had the concept of employing a material that is capable of such controlling as a heat radiating material, and thus have accomplished the present invention.

Accordingly, the present invention provides a heat radiating member as set forth in the following (1) to (4).
(1) A heat radiating member, characterized by comprising a material capable of varying its heat capacity to a desired heat capacity by varying manufacturing conditions.
(2) The heat radiating member as in (1), wherein the material is capable of varying its heat capacity by controlling its bulk density.
(3) The heat radiating member as in (1) or (2), wherein the material is a graphite sheet.
(4) The heat radiating member as in (3), wherein the graphite sheet is capable of varying its heat capacity by controlling its bulk density by varying the weight of expanded graphite per unit volume.

The present invention also provides a circuit board as set forth in the following (5) to (10).
(5) An electronic component module comprising: a substrate main body having a wiring pattern formed on a surface side thereof; and a structure in which an electronic component is connected to the wiring pattern, **characterized in that**: a through hole is provided in a portion of the substrate main body so as to penetrate the substrate main body from the surface side to a back side thereof; a heat radiating member is provided on the back side of the substrate main body so as to close one end of the through hole; and the electronic component is disposed in the through hole so that the electronic component and the heat radiating member are directly in contact with each other.
(6) The circuit board as in (5), wherein the heat radiating member comprises a material capable of varying its heat capacity to a desired heat capacity by varying manufacturing conditions.
(7) The circuit board as in (6), wherein the material is capable of varying its heat capacity by controlling its bulk density.
(8) The circuit board as in (7), wherein the heat radiating member comprises an expanded graphite sheet.
(9) The circuit board as in (8), wherein the bulk density of the expanded graphite sheet is restricted within the range of from 0.3 Mg/m³ to 2.0 Mg/m³.

The present invention also provides an electronic component module as set forth in the following (10) to (12).
(10) An electronic component module using a circuit board as in any one of the foregoing (5) to (9).
(11) The electronic component module as in (10), wherein the electronic component and the heat radiating member are closely adhered to each other by a heat conductive adhesive agent.
(12) The electronic component module as in (10) or (11), wherein the electronic component is an LED module.

The present invention also provides a manufacturing method as in (13) to (19) of an electronic component module.
(13) A method of manufacturing an electronic component module, comprising: a through hole-forming step of forming a through hole at a position at which an electronic component is to be provided in a circuit board main body having a wiring pattern formed on a surface side thereof, the through hole penetrating the circuit board main body from the surface side to a back side thereof; a heat radiating member providing step of providing a heat radiating member so as to close one end of the through hole on the back side of the substrate main body; and an electronic component disposing step of disposing the electronic component into the through hole so that the electronic component and the heat radiating member are directly in contact with each other.
(14) The method of manufacturing an electronic component module as in (13), wherein the heat radiating member comprises a material capable of varying its heat capacity to a desired heat capacity by varying manufacturing conditions.
(15) The method of manufacturing an electronic component module as in (14), using the heat radiating member comprising a material capable of varying its heat capacity by varying its bulk density.
(16) The method of manufacturing an electronic component module as in (15), wherein the heat radiating member comprises a graphite sheet.
(17) The method of manufacturing an electronic component module as in any one of (13) through (16), wherein, in the electronic component disposing step, the electronic component and the heat radiating member are bonded to each other by a heat conductive adhesive agent.
(18) The method of manufacturing an electronic component module as in any one of (13) through (17), wherein the electronic component is an LED module.
(19) The method of manufacturing an electronic component module as in any one of (13) through (18), wherein the electronic component has an electrode, and further comprising a connecting step of electrically connecting the electrode with the wiring pattern.

### ADVANTAGES OF THE INVENTION

The heat radiating member of the present invention comprises a material capable of varying its heat capacity to a desired heat capacity by varying manufacturing conditions, or a material (graphite sheet) capable of varying its heat capacity by controlling its bulk density. Therefore, it is unnecessary to increase or decrease the volume of the heat radiating member according to an increase or decrease of required heat capacity. As a result, it becomes possible to adjust the heat capacity without impairing its good space saving capability. Accordingly, an advantageous effect is exhibited that the degree of freedom in packaging electronic components increases while ensuring sufficient heat radiation characteristics.

In addition, with the graphite sheet, the heat radiating member can be manufactured, for example, by merely press-forming expanded graphite by compressing it (i.e., there is no constraint on the manufacturing method such as carbonizing a material such as polyimide). Therefore, the degree of freedom in shaping is high (i.e., a product with a desired shape can be manufactured easily). In this respect as well, the degree of freedom in packaging of electronic components is improved. Moreover, the heat radiating member can be produced by merely press-forming expanded graphite by compressing it. Thus, there is an advantage that the heat radiating member as well as a circuit board and an electronic component module that use the heat radiating member can be manufactured at low cost.

Furthermore, according to the present invention, the heat radiating member and the electronic component are directly in contact with each other (i.e., heat can be transmitted without using the heat conductive member disposed in the through hole), and therefore, higher heat radiation capability than conventional can be exhibited.
In addition, it is possible to reduce the weight of the heat radiating structure because the graphite sheet has a smaller specific gravity than metal. Also, since the graphite sheet shows better elasticity than metal, the contact area with the electronic component increases, resulting in a higher heat radiation effect. Moreover, since the structure is such that the electronic component is disposed in the through hole formed in the substrate main body, not on the surface of the substrate main body, it is possible to resolve, for example, the problem that the size of the module increases corresponding to the height of the electronic component.

### BEST MODE FOR CARRYING OUT THE INVENTION

The present invention has a configuration in which a heat radiating member is directly in contact with a back side of a heat generating body, i.e., an electronic component. The heat radiating member is in contact with at least a portion of, preferably the entirety of, the back side of the electronic component, so the heat insulation effect of the printed circuit board, which has a low thermal conductivity, can be eliminated. Moreover, by bringing the heat radiating member directly into contact with the back side of the electronic component, it is possible to solve the problem such as an increase in thermal resistance caused in the case where heat is conducted using another member. Here, the embodiment in which they are directly in contact with each other includes an embodiment in which the heat radiating member is brought directly in contact with the back side of the electronic component via a conventional heat radiating member and an embodiment in which the heat radiating member is brought in contact with the back side of the electronic component using an adhesive agent such as silicon grease. For example, a heat radiating structure is essential for the high-intensity LED module of several watts or higher, and an aluminum heat radiating plate or the like is conventionally disposed on the back side. However, the high-intensity LED module and the heat radiating member of the present invention may be brought directly in contact with each other.

For the heat radiating member, it is preferable to use a graphite sheet, which is a material that has a high thermal conductivity, is lighter than aluminum (about 1/2 the weight), shows a low thermal expansion rate, and is less expensive than a sheet obtained by treating a commercially available polymer substance such as polyimide at a high temperature. Here, the graphite sheet should desirably have a thickness of 0.1 mm or greater, and it should be noted that one having a thickness of several centimeters is also referred to as a graphite sheet. The graphite sheet may be processed into various shapes. For example, it is possible to provide a protrusion that is to be fitted in a recessed portion provided in a printed circuit board.

The substantial portion of the best mode of the present invention is that an insulating layer of the electronic component and a graphite sheet that is the heat radiating member are bought directly in close contact with each other when an electronic component is mounted to a circuit board. As a result, high heat radiation capability can be exhibited, and therefore, the temperature increase of the electronic component can be prevented effectively.
The graphite sheet should preferably have a thickness of from 0.1 mm to 1.5 mm, more preferably from 0.3 mm to 1.0 mm, as long as no problem arises in terms of the strength.

The graphite sheet has an excellent feature that the heat capacity thereof can be adjusted by making the bulk density thereof variable. The preferable bulk density of the graphite sheet may be selected as appropriate within the range of from 0.3 Mg/m³ to 2.0 Mg/m³. The reason why the bulk density is restricted in this way is as follows. If the bulk density exceeds 2.0 Mg/m³, the flexibility becomes poor, which may reduce the adhesion capability with the electronic component or the like, although the thermal conductivity in a plane direction becomes high. On the other hand, if the bulk density is less than 0.3 Mg/m³, the thermal conductivity in a plane direction becomes poor although the flexibility increases and the adhesion capability with the electronic component or the like improves.

Here, there is a relationship for the heat capacity C = m · Cp [here, m is mass (g), and Cp is specific heat (J/k), which is 0.7 J/g•K at room temperature (about 23° C)]. Accordingly, the mass changes by varying the bulk density of the graphite sheet (or, the weight of expanded graphite powder per unit volume); therefore, it becomes possible to control the heat capacity of the graphite sheet.

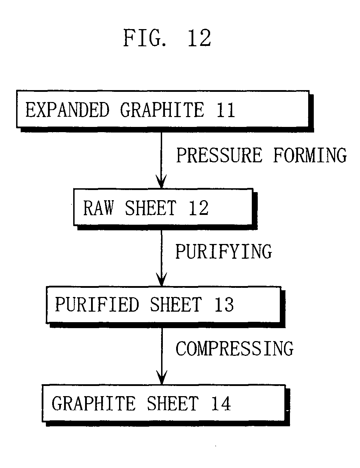

An example of the method of manufacturing the graphite sheet is disclosed in Fig. 12.
Reference numeral 11 in the figure indicates expanded graphite, which is a material for the graphite sheet suitable for the present invention. The expanded graphite 11 is a sheet-like material made of flocculent graphite (expanded graphite) formed by immersing natural graphite or kish graphite in a liquid such as sulfuric acid or nitric acid, and thereafter subjecting it to a heat treatment at 400°C or higher. The expanded graphite 11 has a thickness of 1.0 mm to 50.0 mm and a bulk density of 0.1 Mg/m³ to 0.3 Mg/m³. This expanded graphite 11 is press-formed by compressing it to a thickness of 0.1 mm to 3.0 mm and a bulk density of 0.2 Mg/m³ to 1.1 Mg/m³, to form a raw sheet 12. When compressing the expanded graphite 11 having a thickness of 2.0 mm and a bulk density of 0.1 Mg/m³ to be the raw sheet 12 having a thickness of 0.2 mm and a bulk density of 1.0 Mg/m³, bubbles or the like can be prevented from forming during the compressing, so a raw sheet 12 with uniform quality can be manufactured. This is desirable because variations of thermal conductivity in a graphite sheet 14 can be prevented more reliably.

Thereafter, impurities such as sulfur or iron content contained in the raw sheet 12 are removed using a halogen gas or the like so that the total amount of impurities contained in the raw sheet 12 is 10 ppm or less, especially sulfur is 1 ppm or less, to form a purified sheet 13. It is preferable that the total amount of impurities in the purified sheet 13 be 5 ppm or less, so that the deterioration of the member and the device to which the graphite sheet 14 is fitted can be prevented more reliably.

The method of removing impurities from the raw sheet 12 is not limited to the above-described method, and it is possible to employ the most suitable method depending on the thickness and bulk density of the raw sheet 12.
The purified sheet 13 is compressed by pressure-rolling or the like to a thickness of 0.05 mm to 1.5 mm and a bulk density of 0.3 Mg/m³ to 2.0 Mg/m³, whereby the graphite sheet 14 suitable for the present invention can be formed. The graphite sheet manufactured in the foregoing procedure has a high heat radiation characteristic of 350 w/(m•k) or greater in a plane direction. The details are disclosed in Japanese Patent No. 3691836.
Thus, a preferable embodiment of the graphite sheet according to the present invention is an expanded graphite sheet primarily made of flocculent expanded graphite obtained by expanding acid-treated graphite by heat-treating it.

An electronic component module having a heat radiating structure of the present invention comprises: a substrate main body having electrical wiring on a surface side thereof and a through hole provided so as to penetrate the substrate main body from the surface side to a back side thereof; a graphite sheet provided on the substrate main body so that the through hole is on a back side thereof; and an electronic component that is attached directly to the graphite sheet from the surface side of the substrate main body through the through hole and that generates heat by being supplied with electricity from the electrical wiring. The substrate main body is a common printed circuit board, such as one made of glass epoxy.

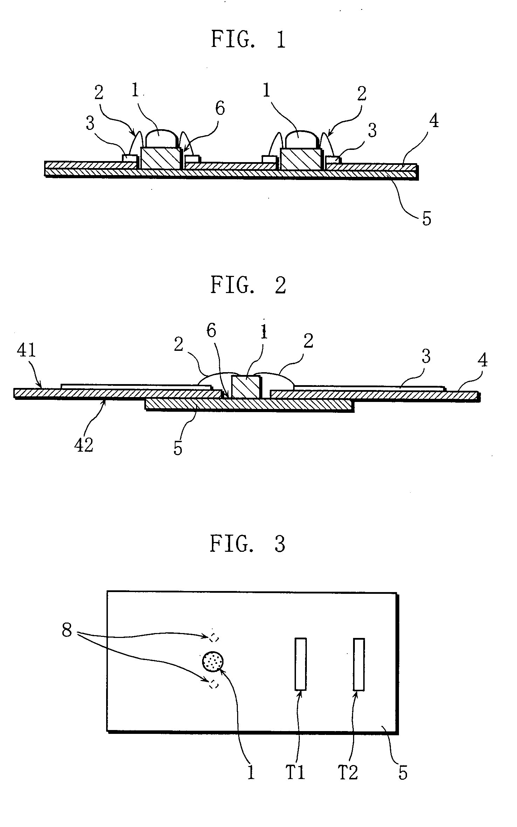

In a first embodiment example of the present invention, electrical wiring 3 (wiring pattern made of a metal) is provided on a surface side 41 of a substrate main body 4, and a heat radiating member 5 made of a graphite sheet (bulk density: 1 Mg/m³) is disposed over the entire surface of a back side 42 of the substrate main body 4, as illustrated in Fig. 1. A through hole 6 is provided in advance at a portion of the substrate main body 4 at which an LED module 1 is to be mounted. The LED module 1 is disposed within the through hole 6 so as to be closely in contact with the heat radiating member 5.

In a second embodiment example of the present invention, the heat radiating member 5 is disposed on a back side 42 of the substrate main body 4, as illustrated in Fig. 2. The area of the heat radiating member 5 is narrower than that in Fig. 1, so the heat radiation effect is enhanced by increasing the thickness thereof. Increasing the thickness of the heat radiating member 5 also has the effect of increasing the strength. Note that reference numeral 2 in Figs. 1 and 2 denotes wires of wire bonding, which electrically connects the LED module 1 with the electrical wiring 3 on the substrate main body 4.
When it is desired to enhance the strength, it is possible to attach a reinforcing member, which is not shown in the figure, onto the back side of the heat radiating member 5. This is common between the configuration of Fig. 1 and that of Fig. 2.

A manufacturing method of the electronic component module comprises a first step of providing a graphite sheet on a back side of a substrate main body having electrical wiring on a surface side thereof and a through hole formed therein so as to penetrate from the surface side to the back side; a second step of attaching an electronic component (the LED module 1 in the foregoing example), which is a heat generating body, directly onto a graphite sheet through the through hole of the substrate main body; and a third step of electrically connecting the electronic component and the electrical wiring on the substrate main body. The first step and the second step may be carried out in any order.

It is preferable that the method of attaching the electronic component be such that the electronic component is attached on the graphite sheet by a heat conductive adhesive agent (e.g., a thermoplastic resin or a thermosetting resin). In this case, it is preferable that the gap between the graphite sheet and the electronic component be filled by the heat conductive adhesive agent so that no gap forms between the contact surfaces of the graphite sheet and the electronic component.

A known plastic that can reversibly be softened by a high temperature may be used as the thermoplastic resin. Specific examples include polyethylene, polypropylene, vinyl chloride, polystyrene, acrylic resin, polyethylene terephthalate (PET), and polycarbonate.
A known plastic that hardens at a high temperature may be used as the thermosetting resin. Specific examples include epoxy resin, phenolic resin, melamine resin, and silicon resin.

Hereinbelow, the details of the present invention will be described with reference to examples, but it should be noted that the present invention is in no way limited to the examples.

### Example 1

In Example 1, the heat radiation effects were confirmed using heat radiating members made of various materials in a heat radiating structure that can effectively radiate heat generated by an LED module.
Generally, the maximum temperature at which an LED can be used is determined by the LED chip surface temperature (junction temperature: Tj). However, in reality, the temperature Tj cannot be measured directly.

Here, the LED has the feature that when the junction temperature increases, the forward voltage (Vf) decreases. Therefore, it was decided to measure the tendency of the change in the junction temperature by measuring the forward voltage (Vf).
The junction temperature can be calculated from the LED voltage obtained in a preliminary experiment and the profile of the junction temperature. From the results, the junction temperature can be calculated with certain accuracy.

The LED module 1 used in the present example has the configuration in which a reflector plate and a lens resin are stacked on a base substrate made by stacking a metal layer, an insulating layer, and the like. The specification of the LED module 1 of the present example is shown below.

### «Specification of the LED module»

Manufacturer: Lumileds Inc. LXHL LW3C
Maximum rated forward current: 1000 (mA)
Upper limit temperature: 135 (°C)
Operating temperature: -40 to 120 (°C)

### «Method of Measurement»

Using the simplified measuring device shown in Fig. 3, the tendency of the change of the junction temperature was measured. In Fig. 3, reference numeral 1 denotes an LED module, reference numeral 5 denotes a heat radiating member, reference numeral 8 denotes an LED mounting hole, and T1 and T2 denote thermometers. The distance from the LED module 1 to the thermometer T1 is 32 mm, and the distance from the LED module 1 to the thermometer T2 is 52 mm.

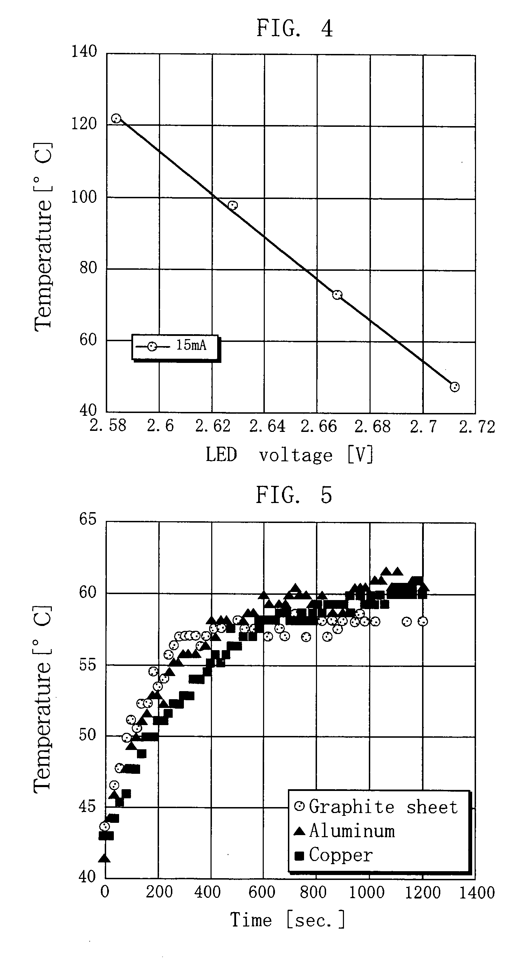

The procedure of the measurement was as follows.
First, rated current 700 [mA] was passed through the LED module 1 for 20 minutes to cause it to emit light, and at the same time, the measurement was started. Subsequently, the temperatures of the thermometers T1 and T2 and the voltage of the LED were measured every 20 seconds. The voltage of the LED module 1 is recorded automatically by the measuring device as necessary (every 0.1 seconds). When recording the temperatures, the current passed through the LED was dropped to 15 [mA] for about 1 second. The reason is that it is necessary to prevent the junction temperature from rising due to the light emission of the LED during the measurement.
The relationship between forward voltage (Vf) and junction temperature (Tj) was calculated in a preliminary experiment. The basic characteristics of the LED module 1 used in the present example are shown in Fig. 4.

### «Comparative Test»

Using the configuration and the measure method as described above, a comparative test was conducted for comparing the heat radiation capabilities in the case where the heat radiating member 5 was copper, aluminum, and the graphite sheet. The thickness of the heat radiating member 5 was 1.5 mm in the cases of copper and aluminum, and 1.5 mm in the case of the graphite sheet. A graphite sheet (bulk density: 2.0 Mg/m³, weight: 18 g) manufactured by the applicant was used as the graphite sheet.

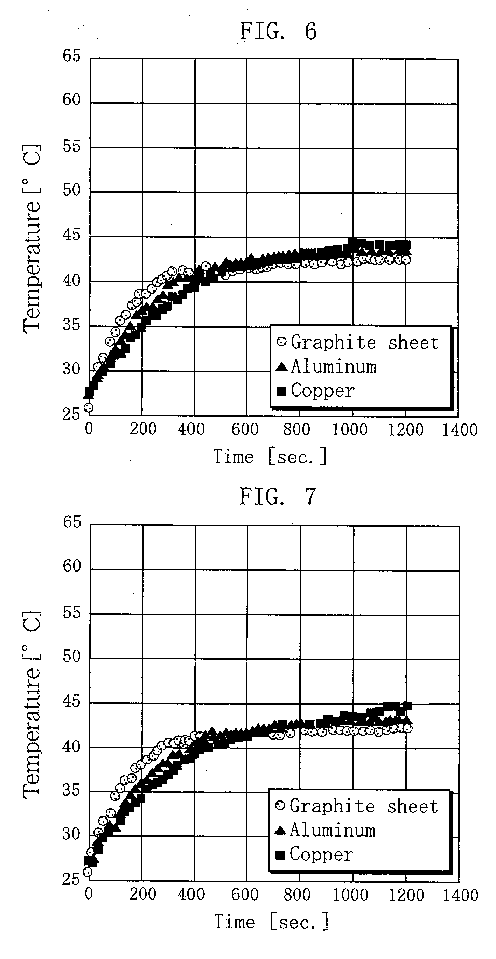

Fig. 5 is a graph illustrating the results of comparison of the junction temperatures of heat radiating members made of different materials. Fig. 6 is a graph illustrating the temperature change shown by the thermometer T1. Fig. 7 is a graph illustrating the temperature change shown by the thermometer T2.

As seen from Fig. 5, in a non-steady state (approximately in the range from 0 second to 500 seconds), the graphite sheet shows a quicker temperature rise than copper and aluminum. The reason is that the graphite sheet has a small heat capacity. Although it is a commonplace technique to change its heat capacity by varying the size or the like with the heat radiating member made of a metal, it is difficult to improve the rise time in a non-steady state and control the temperature level in a steady state by controlling the physical properties themselves.

In addition, it is understood from Figs. 6 and 7 that the highest heat radiation capability is exhibited when using the graphite sheet as the heat radiating member 5.
Conventionally, redesigning by changing the shape of the heat sink or the like cannot result in an improvement of several degrees, but the heat radiating structure of the present example can achieve an improvement exceeding several degrees merely by changing the material for the heat radiating member, so the significance of the invention is extremely great.

### Example 2

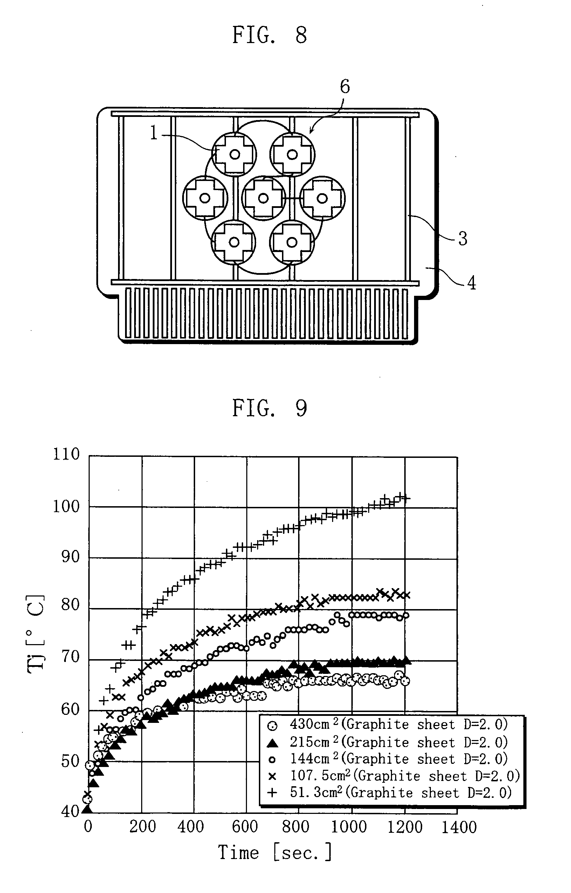

In the present example, a temperature comparative test was conducted for graphite sheets having different areas. In the present example, 7 LED modules 1 as used in Example 1 were mounted on the substrate 4, as illustrated in Fig. 8. Silicon grease (G-747) was applied between the heat radiating member 5 and the LED modules 1. Application of the silicon grease can increase the area in which the heat radiating member and the LED modules are in close contact, so it is possible to obtain further higher heat radiation effects. The specification of the heat radiating member 5 is as follows, and other configurations are the same as in Example 1. Accordingly, all the graphite sheets had a bulk density of 2.0 Mg/m³ and a thickness D of 1.5 mm.

### «Specification of the Heat Radiating Member»

Manufacturer: Toyo Tanso Co., Ltd.
Model: PF-150UHP
Thickness: 1.5 mm
Shape etc.:
   Experimental example 1 (The shape is in a squared shape, the area is 430 cm², and the mass is 129 g. Therefore, the heat capacity is 45.15 J/K.)
   Experimental example 2 (The shape is in a squared shape, the area is 215 cm², and the mass is 64 g. Therefore, the heat capacity is 22.54 J/K.)
   Experimental example 3 (The shape is in a squared shape, the area is 144 cm², and the mass is 43 g. Therefore, the heat capacity is 15.12 J/K.)
   Experimental example 4 (The shape is in a squared shape, the area is 107.5 cm², and the mass is 32g. Therefore, the heat capacity is 11.27 J/K.)
   Experimental example 5 (The shape is in a regular hexagonal shape, the area is 51.3 cm², and the mass is 15 g. Therefore, the heat capacity is 5.39 J/K.)
   It should be noted that the experimental example 1 has the same area as that of the substrate main body 4.

Fig. 9 is a graph illustrating the results of comparison of the junction temperatures of heat radiating members having different areas. It is confirmed from Fig. 9 that the heat radiation capability improves correspondingly to the area of the heat radiating member 5. In the present example, 7 LED modules were mounted. However, when a greater number of LED modules are integrated and mounted, it is expected that the amount of heat generated increases significantly. In such a case, the heat radiating structure of the present example is extremely effective.

### Example 3

In the present example, the temperature changes of heat radiating members made of different materials were observed in a condition with a fan and in a condition without a fan.
The specification of the fan used in the present example is shown below. The fan was disposed 10 cm away from the back side of the graphite sheet.

### «Specification of the Fan»

Manufacturer: Japan Servo Co., Ltd.
Model: VE55B5
Maximum air flow: 0.55 (m³/min)
Maximum static pressure: 4.3 (mmH₂O)
Noise: 30 (dB[A])

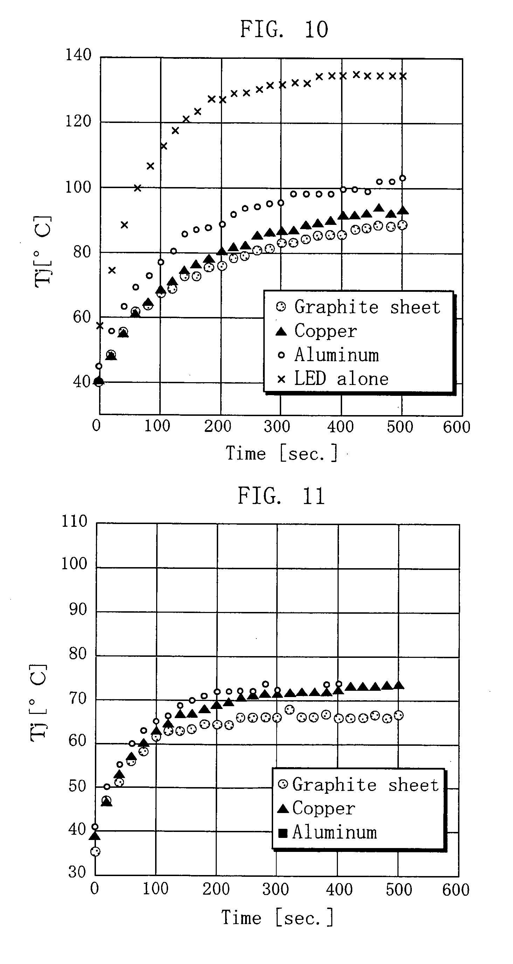

Fig. 10 shows the results of the measurement in a condition without a fan, and Fig. 11 shows the results of the measurement in a condition with a fan. It is confirmed from Figs. 10 and 11 that high heat radiation effect can be obtained by providing a fan additionally.

### INDUSTRIAL APPLICABILITY

The present invention is suitable for cooling electronic components that generate a large amount of heat, especially for a high-intensity LED lighting device that is packaged at a high density. An example of the use of the high-intensity LED lighting device is an automobile headlight.

### BRIEF DESCRIPTION OF THE DRAWINGS

[Fig. 1] Fig. 1 is view illustrating a first configuration example of the present invention.
[Fig. 2] Fig. 2 is view illustrating a second configuration example of the present invention.
[Fig. 3] Fig. 3 is a schematic view illustrating the configuration of a simplified measuring device pertaining to Example 1.
[Fig. 4] Fig. 4 is a graph illustrating basic characteristics of an LED module according to Example 1.
[Fig. 5] Fig. 5 is a graph illustrating calculation results for the junction temperatures of heat radiating members made of different materials.
[Fig. 6] Fig. 6 is a graph illustrating the measurement results with a thermometer T1.
[Fig. 7] Fig. 7 is a graph illustrating the measurement results with a thermometer T2.
[Fig. 8] Fig. 8 is a schematic view illustrating a substrate on which an LED module according to Example 2 is mounted.
[Fig. 9] Fig. 9 is a graph illustrating the results of measurement for temperature changes of heat radiating members having different areas.
[Fig. 10] Fig. 10 is a graph illustrating the results of measurement for temperature changes of various heat radiating members in a condition without a fan.
[Fig. 11] Fig. 11 is a graph illustrating the results of measurement for temperature changes of various heat radiating members in a condition with a fan.
[Fig. 12] Fig. 12 is a flow-chart illustrating a manufacturing procedure for a graphite sheet that is suitable for a heat radiating member of the present invention.

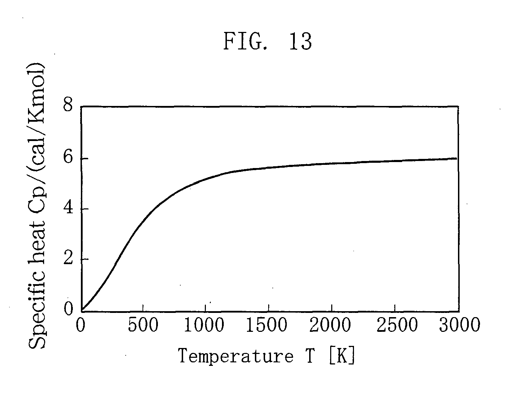

[Fig. 13] Fig. 13 is a graph illustrating the relationship between temperature T versus specific heat Cp in a graphite sheet.

### DESCRIPTION OF REFERENCE NUMERALS

- 1: LED module
- 2: wire
- 3: electrical wiring (wiring pattern)
- 4: substrate main body
- 5: heat radiating member
- 6: through hole

## Claims

1. A heat radiating member, **characterized by** comprising a material capable of varying its heat capacity to a desired heat capacity by varying manufacturing conditions.

2. The heat radiating member according to claim 1, wherein the material is capable of varying its heat capacity by controlling its bulk density.

3. The heat radiating member according to claim 1 or 2, wherein the material is a graphite sheet.

4. The heat radiating member according to claim 3, wherein the graphite sheet is capable of varying its heat capacity by controlling its bulk density by varying the weight of expanded graphite per unit volume.

5. A circuit board comprising a substrate main body having a wiring pattern formed on a surface side thereof and a structure in which an electronic component is connected to the wiring pattern, **characterized in that**:
a through hole is provided in a portion of the substrate main body so as to penetrate the substrate main body from the surface side to a back side thereof; a heat radiating member is provided on the back side of the substrate main body so as to close one end of the through hole; and the electronic component is disposed in the through hole so that the electronic component and the heat radiating member are directly in contact with each other.

6. The circuit board according to claim 5, wherein the heat radiating member comprises a material capable of varying its heat capacity to a desired heat capacity by varying manufacturing conditions.

7. The circuit board according to claim 6, wherein the material is capable of varying its heat capacity by controlling its bulk density.

8. The circuit board according to claim 7, wherein the heat radiating member comprises an expanded graphite sheet.

9. The circuit board according to claim 8, wherein the bulk density of the expanded graphite sheet is restricted within the range of from 0.3 Mg/m³ to 2.0 Mg/m³.

10. An electronic component module using a circuit board according to any one of claims 5 to 9.

11. The electronic component module according to claim 10, wherein the electronic component and the heat radiating member are closely adhered to each other by a heat conductive adhesive agent.

12. The electronic component module according to claim 10 or 11, wherein the electronic component is an LED module.

13. A method of manufacturing an electronic component module, comprising:
a through hole-forming step of forming a through hole at a position at which an electronic component is to be provided in a substrate main body having a wiring pattern formed on a surface side thereof, the through hole penetrating the substrate main body from the surface side to a back side thereof;
a heat radiating member providing step of providing a heat radiating member so as to close one end of the through hole on the back side of the substrate main body; and
an electronic component disposing step of disposing the electronic component into the through hole so that the electronic component and the heat radiating member are directly in contact with each other.

14. The method of manufacturing an electronic component module according to claim 13, wherein the heat radiating member comprises a material capable of varying its heat capacity to a desired heat capacity by varying manufacturing conditions.

15. The method of manufacturing an electronic component module according to claim 14, that uses the heat radiating member comprising a material capable of varying its heat capacity by varying its bulk density.

16. The method of manufacturing an electronic component module according to claim 15, wherein the heat radiating member comprises a graphite sheet.

17. The method of manufacturing an electronic component module according to any one of claims 13 through 16, wherein, in the electronic component disposing step, the electronic component and the heat radiating member are bonded to each other by a heat conductive adhesive agent.

18. The method of manufacturing an electronic component module according to any one of claims 13 through 17, wherein the electronic component is an LED module.

19. The method of manufacturing an electronic component module according to any one of claims 13 through 18, wherein the electronic component has an electrode, and further comprising a connecting step of electrically connecting the electrode with the wiring pattern.
